(19) Europäisches Patentamt / European Patent Office / Office européen des brevets

(11) **EP 3 037 381 B1**

(12) **FASCICULE DE BREVET EUROPEEN**

(45) Date de publication et mention
de la délivrance du brevet:
**30.03.2022   Bulletin 2022/13**

(21) Numéro de dépôt: **15202061.6**

(22) Date de dépôt: **22.12.2015**

(51) Classification Internationale des Brevets (IPC):
**B81B 3/00** *(2006.01)*      **H01H 1/00** *(2006.01)*

(52) Classification Coopérative des Brevets (CPC):
**B81B 3/0051; H01H 1/0036;** B81B 2201/032;
B81B 2201/037; B81B 2203/051; H01H 2001/0078

(54) **DISPOSITIF DE TRANSFORMATION D'UN MOUVEMENT HORS PLAN EN UN MOUVEMENT DANS LE PLAN ET/OU INVERSEMENT**

VORRICHTUNG ZUR UMWANDLUNG EINER BEWEGUNG AUS DER EBENE IN EINE BEWEGUNG IN DER EBENE BZW. UMGEKEHRT

DEVICE FOR TRANSFORMING AN OUT-OF-PLANE MOVEMENT INTO A MOVEMENT IN THE PLANE AND/OR VICE VERSA

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **23.12.2014   FR 1463236**

(43) Date de publication de la demande:
**29.06.2016   Bulletin 2016/26**

(73) Titulaire: **Commissariat à l'Énergie Atomique et aux Énergies Alternatives
75015 Paris (FR)**

(72) Inventeur: **HILT, Thierry
38660 La Terrasse (FR)**

(74) Mandataire: **Brevalex
95, rue d'Amsterdam
75378 Paris Cedex 8 (FR)**

(56) Documents cités:
EP-A2- 1 170 248      WO-A2-02/04991
FR-A1- 2 945 835      JP-A- H06 160 750
US-A1- 2012 279 838      US-B1- 8 234 951

**Description**

## DOMAINE TECHNIQUE ET ÉTAT DE LA TECHNIQUE ANTÉRIEURE

La présente invention se rapporte à un dispositif de transformation d'un mouvement hors plan en un mouvement dans le plan et/ou de transformation d'un mouvement dans le plan en un mouvement hors plan, en particulier dans les microsystèmes et ou nanosystèmes, et à un actionneur comportant un tel dispositif.

Dans les systèmes microélectromécaniques (MEMS pour MicroElectroMechanical Systems en terminologie anglaise) et/ou les systèmes nanoélectromécaniques (NEMS pour NanoElectroMechanical System en terminologie anglaise), on cherche à réaliser des microactionneurs et/ou nanoactionneurs pour mettre en mouvement des objets, par exemple pour réaliser des microcommutateurs. On cherche plus particulièrement à réaliser des actionneurs dans le plan du MEMS et/ou NEMS

Il existe des actionneurs de type électrostatique comportant un peigne fixe et un peigne mobile dont les doigts sont interdigités et entre lesquels une différence de tension est imposée, ce qui provoque l'apparition des forces électrostatiques qui tendent à rapprocher les doigts et ainsi à mettre en mouvement le peigne mobile. Ce type d'actionneur présente l'avantage de fournir une actuation dans le plan mais a l'inconvénient de ne présenter qu'une énergie limitée pour réaliser une actuation, pour une surface de dispositif donnée.

Il existe par ailleurs des actionneurs mettant en œuvre des matériaux électroactifs, tels que des matériaux piézoélectriques. Par exemple, l'actionneur comporte une poutre en porte-à-faux, de type cantilever, ancrée sur un substrat par une extrémité sur laquelle un tel matériau piézoélectrique est déposé. Lorsqu'un courant électrique traverse le matériau piézoélectrique, celui-ci se contracte provoquant une courbure hors-plan de la poutre, son extrémité libre s'écartant ou se rapprochant du substrat. Un tel actionneur a une énergie suffisante mais Il s'agit d'un actionneur hors plan.

Le document US8234951 décrit une plateforme MEMS bistable convertissant un mouvement de rotation en un mouvement hors-plan, comportant des poutres incurvées présentant une extrémité fixe et une extrémité libre se déplaçant sur un cercle. La plateforme est fixée au centre des poutres.

## EXPOSÉ DE L'INVENTION

C'est par conséquent un but de la présente invention d'offrir un nouveau dispositif de transformation d'un mouvement hors plan en un mouvement dans le plan et/ou inversement, et plus particulièrement un actionneur dans le plan.

Le but énoncé ci-dessus est atteint par un dispositif de transformation d'un déplacement hors plan en un mouvement dans le plan et/ou inversement comportant au moins un élément apte à se déformer hors plan lorsqu'un stimulus lui est appliqué, l'élément déformable comprenant une extrémité ancrée sur un substrat et une extrémité libre par rapport au substrat, et des moyens de guidage en translation de l'extrémité libre, le guidage étant dans le plan.

En d'autres termes on met en œuvre au moins un élément de type cantilever que l'on déforme hors plan en contraignant son extrémité libre à se déplacer en translation dans le plan. Ainsi en se déformant, l'élément de type cantilever impose à son extrémité libre de se déplacer en se rapprochant de l'extrémité ancrée tout en restant dans le plan. On peut par exemple obtenir un actionneur de translation dans le plan, la direction de translation étant parallèle à la direction contenant l'extrémité ancrée et l'extrémité libre. Inversement en déplaçant dans le plan l'extrémité libre, il est possible de déformer hors plan l'élément de type cantilever.

Dans un exemple particulièrement avantageux, le dispositif comporte un élément mobile en rotation autour d'un axe perpendiculaire au plan, qui est relié mécaniquement à deux éléments déformables de sorte que, lorsqu'un stimulus est appliqué à l'un des éléments déformables, celui-ci se déforme hors du plan et l'extrémité libre se déplace dans le plan en se rapprochant de l'extrémité ancrée, ce qui provoque la rotation de l'élément mobile. Ainsi, en appliquant alternativement des potentiels électriques aux deux éléments déformables, nous obtenons un déplacement en rotation de part et d'autre d'une position à l'équilibre.

Dans le cas d'un dispositif MEMS, la position d'équilibre est la position de fabrication du MEMS.

Dans un exemple de réalisation, un élément guidé en translation est relié mécaniquement à l'élément mobile en rotation de sorte que le déplacement en rotation de l'élément mobile provoque un déplacement en translation de l'élément mobile en translation. Par exemple la direction de l'élément mobile en translation est perpendiculaire à la direction comprenant l'extrémité ancrée et l'extrémité libre des éléments déformables.

L'élément déformable peut être du type bilame, l'élément déformable comportant un matériau électroactif qui se contracte lorsqu'un champ électrique lui est appliqué, ou l'élément déformable comportant deux matériaux présentant des coefficients de dilatation thermique différents, l'élément se courbant lorsqu'il est échauffé au-delà d'une température donnée.

Le dispositif de transformation de mouvement peut être mis en œuvre pour réaliser un actionneur ou un dispositif de récupération d'énergie.

La présente invention a alors pour objet un système tel que défini dans la revendication 1.

Le premier élément déformable peut être une membrane.

Les moyens de guidage sont par exemple formés par des poutres déformables s'étendant perpendiculairement à la première direction. Les poutres peuvent se déformer avantageusement au moins en flexion.

De préférence, les moyens aptes à appliquer le ou les stimuli appliquent le ou les stimuli sans contact avec le ou les éléments déformables.

Dans un exemple de réalisation, le premier élément déformable est un bilame et le stimulus est un apport de chaleur.

Dans un autre exemple de réalisation, le premier élément déformable comporte un dépôt d'un matériau électroactif et le stimulus est l'application d'un champ électrique sur ledit dépôt. Le matériau électroactif peut être un matériau piézoélectrique et le champ électrique peut être généré par des électrodes disposées de part et d'autres et/ou de façon coplanaire audit dépôt de matériau piézoélectrique.

Le système selon l'invention permet de faire tourner l'élément mobile en rotation autour d'une position neutre.

Les deux deuxièmes extrémités libres peuvent être guidées le long de la première direction et l'élément mobile en rotation peut être relié mécaniquement aux deuxièmes extrémités libres des deux éléments déformables desdits dispositifs.

Les liaisons mécaniques aptes à se déformer sont par exemple des poutres flexibles.

Le système peut comporter également un élément mobile en translation dans le plan relié mécaniquement à l'élément mobile en rotation de sorte que la rotation de l'élément mobile en rotation provoque la translation dans le plan de l'élément mobile en translation.

Le système comporte avantageusement des moyens de guidage en translation dans le plan de l'élément mobile en translation.

Les moyens de guidage en translation de l'élément mobile en translation peuvent guider l'élément mobile en translation selon une direction orthogonale à la première direction. L'élément mobile en rotation peut être relié mécaniquement à l'élément mobile en translation par des poutres flexibles.

L'élément mobile en rotation est par exemple situé entre les deux éléments déformables et l'élément mobile en translation a la forme d'un cadre entourant les deux éléments déformables, l'élément mobile en rotation étant articulé sur un bord intérieur de l'élément mobile en translation en forme de cadre.

La présente invention a également pour objet un actionneur comportant au moins un dispositif de transformation selon l'invention ou au moins un système selon l'invention et une unité de commande envoyant un stimulus au(x) dispositifs.

La présente invention a également pour objet un actionneur comportant au moins un système selon l'invention et une unité de commande envoyant un stimulus à chacun des dispositifs, les stimuli étant déphasés de π.

La présente invention a également pour objet un actionneur en translation comportant au moins un système selon l'invention et une unité de commande envoyant un stimulus à chacun des dispositifs.

Selon une caractéristique additionnelle, le stimulus est sinusoïdal.

La présente invention a également pour objet un compresseur comportant une cavité, un piston mobile dans la cavité, au moins deux actionneurs de translation selon l'invention, chacun des pistons étant relié mécaniquement à un élément mobile en translation de sorte que le déplacement relatif des pistons génère une augmentation de pression dans la cavité.

Les premier et deuxième pistons sont avantageusement conformés en spirale et sont imbriqués l'un dans l'autre, de sorte à créer des poches de fluide entre les spirales.

La présente invention a également pour objet un système de récupération d'énergie comportant un récupérateur d'énergie comportant au moins un dispositif de transformation selon l'invention ou au moins un système selon l'invention et une unité collectant le courant électrique généré par ledit dispositif ou ledit système.

On peut récupérer de l'énergie en utilisant la déformation de la membrane en particulier lorsqu'elle comporte un matériau piézoélectrique. En effet, la déformation de la membrane génère dans les électrodes associées au matériau piézoélectrique une différence de potentiel électrique qui peut être utilisée.

**BRÈVE DESCRIPTION DES DESSINS**

La présente invention sera mieux comprise sur la base de la description qui va suivre et des dessins en annexe sur lesquels:

- les figures 1A et 1B sont des représentations schématiques d'une vue de côté d'un exemple de dispositif de transformation de mouvement au repos et dans un état d'actionnement,
- la figure 1C est une vue de dessus d'un exemple de réalisation pratique d'un dispositif des figures 1A et 1B,
- la figure 2 est une représentation schématique d'une vue de dessus d'un autre exemple de réalisation d'un dispositif de transformation de mouvement au repos,
- la figure 3 est une représentation schématique du dispositif de la figure 2 dans un premier état d'actionnement,
- la figure 4 est une représentation schématique du dispositif de la figure 2 dans un deuxième état d'actionnement,
- la figure 5 est une représentation schématique du dispositif de la figure 2 dans un troisième état d'actionnement,
- la figure 6 est une représentation schématique d'un actionneur comportant trois dispositifs à transformation de mouvement,
- la figure 7 est une vue de dessus d'une réalisation pratique d'un microdispositif de transformation de mouvement,

les figures 8A et 8B sont des vues de dessus et de dessous d'un exemple de compresseur mettant en œuvre des dispositifs de la figure 7,
- les figures 9A à 9J sont des représentations schématiques de différentes étapes de réalisation d'un dispositif de conversion de mouvement,
- la figure 10 est une représentation graphique des signaux appliqués aux membranes 4, 104 de l'actionneur du dispositif des figures 2 à 5.

## EXPOSÉ DÉTAILLÉ DE MODES DE RÉALISATION PARTICULIERS

Dans la description qui va suivre le dispositif de transformation d'un mouvement hors plan en un mouvement dans le plan et/ou inversement sera décrit dans son application à un actionneur. Mais la présente invention ne se limite pas à l'application à un actionneur mais à tous dispositifs pouvant mettre en œuvre une telle transformation de mouvement.

Nous entendons par «élément déformable» dans la présente demande, un élément présentant une configuration initiale, qui peut-être déformé de manière élastique sous l'application d'un stimulus par exemple une contrainte résultant d'un échauffement ou de l'application d'un champ électrique ou magnétique ou encore de l'application d'une accélération. L'élément déformable reprenant sa configuration initiale après disparition de la contrainte.

Par ailleurs, lorsqu'il sera fait référence au plan il s'agit du plan moyen du dispositif qui est parallèle au plan du substrat.

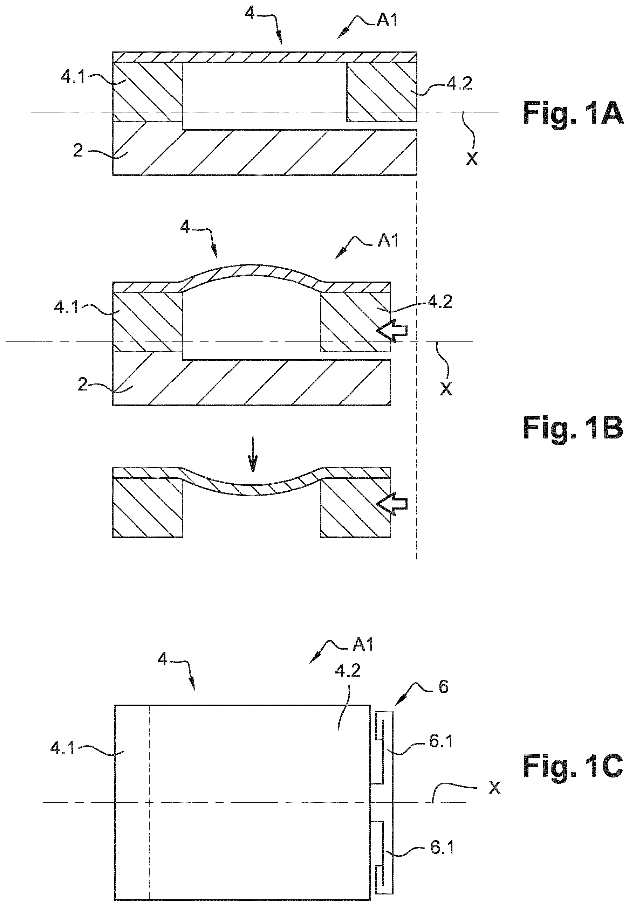

Sur les figures 1A à 1C, on peut voir un exemple d'un actionneur A1 selon l'invention comportant un substrat 2 et un élément déformable 4 s'étendant suivant une direction X contenu dans le plan du substrat. L'élément déformable 4 comporte une première extrémité 4.1 ancrée sur le substrat, désignée extrémité fixe, et une deuxième extrémité 4.2 libre par rapport au substrat 2, désignée extrémité libre ou mobile. On entend par "extrémité libre par rapport au substrat" une extrémité apte à avoir un déplacement par rapport au substrat, ce déplacement pouvant être limité ou non. L'extrémité fixe 4.1 et l'extrémité libre 4.2 sont alignées sur la direction X.

L'élément déformable est par exemple une poutre ou plus avantageusement une membrane, comme cela est représenté sur la figure 1C, qui peut se déformer hors plan sous l'application d'un stimulus. Dans la suite de la description, on désignera l'élément déformable par "membrane".

Par exemple la membrane est un bilame et le stimulus est un apport de chaleur, qui provoque la courbure du bilame tant que le bilame n'est plus à la température de repos. Un bilame est formé de deux lames en matériaux différents présentant des coefficients de dilatation différents, les deux lames étant solidarisées par laminage, soudage, collage, brasure ou directement par dépôt par exemple par pulvérisation directe d'un deuxième matériau sur un premier matériau de sorte à former un élément hétérogène, monolithique.

Alternativement et de manière préférée, la membrane comporte une couche support suspendu et au moins une couche de matériau électroactif, par exemple un matériau piézoélectrique qui se déforme lorsqu'il est soumis à un champ électrique. Une couche de matériau électroactif peut être formée sur l'une des faces de la couche support. Le matériau piézoélectrique étant déformé sur la membrane qui n'est pas déformée, il se forme un effet bilame qui a pour effet de courber l'ensemble membrane - matériau piézoélectrique. Le sens de la courbure varie selon que le matériau piézoélectrique le sens du champ électrique. Il en va de même pour un bilame thermique : si l'on se trouve au dessus ou en dessous de la température de référence, le sens de la courbure change. Le champ électrique est généré par des électrodes disposées sur et de part et d'autres et/ou de façon coplanaire au dépôt de matériau piézoélectrique. La forme de la membrane déformée présente deux points d'inflexion. En d'autres termes, la membrane présente une courbure dans un sens à son centre et des courbures dans l'autre sens à proximité des ses points de fixation. L'énergie développée par le matériau électroactif étant directement dépendante du volume de matériau actif, il est préférable de déposer une grande quantité de matériau. Ainsi, il est avantageux de déposer du matériau électroactif sur toutes les zones où une courbure peut être provoquée, par exemple au centre et sur les bords de la membrane. Puisque les sens de courbure sont inversés entre le centre et les bords, en choisissant des matériaux présentant un comportement symétrique en fonction de leur polarisation par ce champ électrique et en soumettant le ou les matériaux électroactifs situés au centre et sur les bords à des champs électriques inversés, on bénéficie d'une grande quantité de matériau électroactif qui présente le même sens de courbure quel que soit son emplacement sur la membrane.

L'actionneur A1 comporte également des moyens de guidage 6 représenté sur la figure 1C pour guider en translation l'extrémité libre de la membrane dans le plan.

De manière avantageuse dans un microactionneur ou nanoactionneur et comme cela est représenté sur la figure 1C, les moyens de guidage sont formés par des poutres 6.1 aptes à se déformer en flexion dans le plan. Dans l'exemple représenté, deux paires de poutres de guidage s'étendant perpendiculairement à l'axe direction X sont mises en œuvre. Dans cet exemple, les poutres de guidage forment également des poutres de suspension de l'extrémité libre par rapport au substrat.

Le fonctionnement de l'actionneur A1 va être décrit.

Nous prenons le cas d'un actionnement mettant en œuvre un matériau électroactif. En l'absence de champ électrique, la membrane est plane (figure 1A et 1C).

Lorsqu'un champ électrique est appliqué au matériau électroactif, la membrane se courbe. Puisqu'elle est ancrée sur le substrat par son extrémité fixe 4.1, c'est son extrémité libre qui se déplace. Les poutres 6 fléchissent sous l'effort en traction exercé par l'extrémité libre 4.2 de la membrane. Les poutres guident en translation dans le plan l'extrémité libre 4.2, qui est contrainte de se déplacer dans le plan le long de la direction X. Du fait de la courbure de la membrane, l'extrémité libre 4.2 se rapproche de l'extrémité fixe 4.1.

On réalise ainsi un actionneur simple, offrant une énergie suffisante. Plus généralement, on réalise un dispositif permettant de convertir le mouvement hors plan de la membrane en un mouvement de translation dans le plan de l'extrémité libre et/ou inversement.

L'actionneur A1 peut par exemple être utilisé pour aligner très précisément des objets, comme des extrémités de fibres optiques par exemple. On peut envisager une fibre optique fixe et une fibre optique dont une extrémité serait solidaire de l'extrémité libre de la membrane. En actionnant la membrane, il est possible d'aligner ou non les deux fibres optiques. On forme ainsi un commutateur optique, il est possible par exemple de réaliser un routeur. Cet exemple n'est en aucun cas limitatif.

Dans l'exemple représenté, la membrane se déforme, sa courbure étant orientée vers le bas. Comme expliqué ci-dessus en changeant la polarisation de la couche de matériau électroactif sur la membrane, l'orientation de la concavité est modifiée. Mais le sens de déplacement de l'extrémité libre est encore en rapprochement de l'extrémité libre.

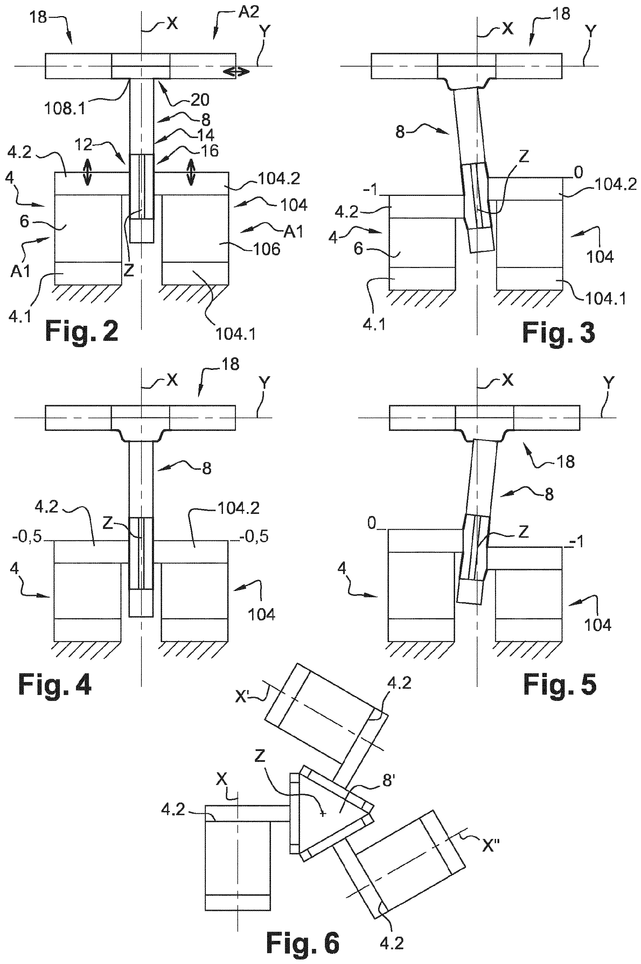

Sur les figures 2 à 5, on peut voir un autre exemple de réalisation d'un actionneur A2 permettant un déplacement en translation dans une direction perpendiculaire à la direction X.

L'actionneur A2 comporte deux actionneurs A1 côte à côte et parallèles, i.e. les membranes 4, 104 s'étendant le long de direction parallèle à la direction X.

L'actionneur A2, comporte également un premier élément mobile en rotation 8 autour d'un axe Z orthogonal au plan. Celui-ci est disposé entre les deux membranes 4, 104. Le premier élément mobile 8 s'étend le long de la direction X. L'élément mobile est relié mécaniquement aux extrémités libres 4.2, 104.2 de chacune des membranes 4, 104. Plus particulièrement, l'élément mobile 8 comporte une face latérale 10 reliée par une liaison mécanique 12 à l'extrémité libre 4.2 et une face latérale opposée 14 reliée par une liaison mécanique 16 à l'extrémité libre 104.2. Les liaisons mécaniques 12 et 16 aptes à se déformer dans une direction transversale à la direction X. Les liaisons mécaniques 12 et 16 comportent avantageusement chacune deux poutres aptes à se déformer s'étendant parallèlement à l'axe X s'étendant de part et d'autre de l'extrémité libre.

L'actionneur A2 comporte également un deuxième élément mobile 18 guidé en translation le long d'une direction Y, celui-ci s'étendant le long de la direction Y. Cinq degrés de liberté du deuxième élément mobile 18 sont bloqués. Les moyens de guidage en translation du deuxième élément mobile sont par exemple du même type que ceux mis en œuvre pour guider les extrémités libres des membranes, i.e. ils comportent des poutres aptes à se déformer en flexion.

Le deuxième élément mobile 18 est relié par une liaison mécanique 20 à une extrémité 8.1 du premier élément mobile 8 située à l'extérieur de la zone délimitée entre les deux membranes 4, 104. La liaison mécanique 20 est apte à se déformer le long de la direction X. Dans l'exemple représenté, la liaison mécanique 20 est sensiblement au milieu du deuxième élément mobile mais une liaison mécanique 20 dans une autre partie du deuxième élément mobile ne sort pas du cadre de la présente invention.

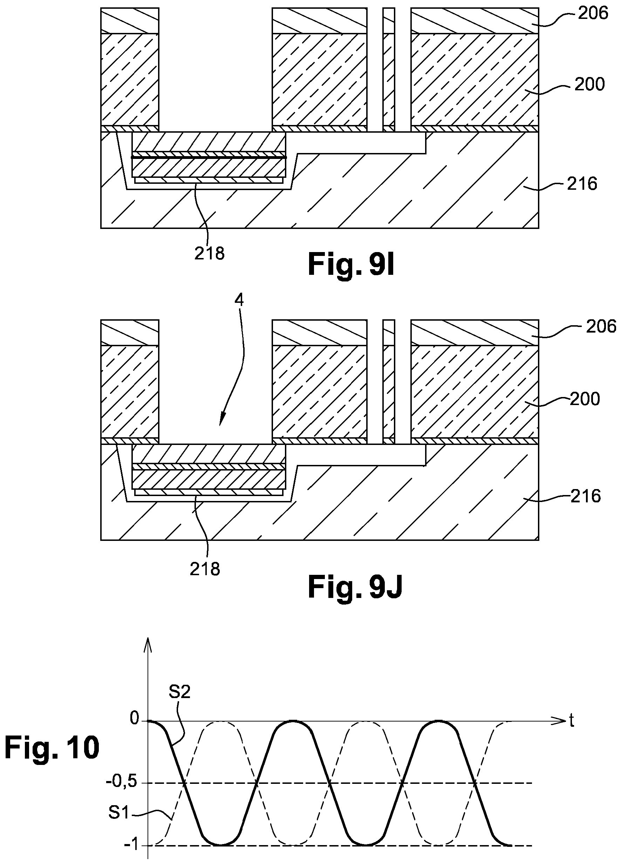

Les deux actionneurs A1 sont actionnés avec un déphasage de phase de π. Les signaux appliqués aux membranes 4, 104 en fonction du temps t sont représentés sur le graphique de la figure 10. Le signal S1 est celui appliqué à la membrane 4 et le signal S2 est celui appliqué à la membrane 104. Dans l'exemple représenté, les signaux sont sinusoïdaux. Mais on pourrait envisager qu'ils présentent une autre forme, par exemple qu'ils soient en créneau.

Dans la configuration de la figure 2, aucun signal n'est appliqué aux membranes, elles sont au repos.

Les déplacements varient entre un extremum négatif, noté -1 et 0, la valeur -1 correspond à une déformation maximale de la membrane et la valeur 0 correspond à aucune déformation de la membrane.

A t = 0 sur le graphe de la figure 10, le déplacement S1 est à -1, la membrane 4 est courbée, le déplacement S2 est à 0, la membrane 104 est au repos, elle est plane. L'extrémité libre 4.2 se déplace en translation le long de la direction X vers l'extrémité fixe 4.1. Cet état est représenté sur la figure 3. Du fait de la liaison 12 entre la face latérale 10 du premier élément mobile 8 et l'extrémité libre 4.2 de la membrane, le premier élément mobile pivote du côté de la membrane 4 autour d'un axe Z perpendiculaire au plan. Les poutres des liaisons 12 et 16 se déforment.

A t = 1 sur le graphe de la figure 10, le signal S1 est à -0,5 et le signal S2 est à -0, 5, les deux membranes 4, 104 présentent les mêmes courbures intermédiaires, le premier élément mobile 8 subit alors une force de traction de la part de l'extrémité libre 104.2 de la membrane 104 tandis que la force de traction appliquée par l'extrémité libre 4.2 de la membrane 4 sur le premier élément 8 diminue. Le premier élément mobile 8 reprend une position alignée avec l'axe X (figure 4). La liaison entre le premier élément mobile 8 et le deuxième élément mobile 18 est réalisée par des poutres s'étendant le long de l'axe Y, ainsi le deuxième élément mobile 18 peut être en position 0 alors que les membranes 4 et 104 sont en position -0.5.

A t = 2, le signal S2 est à -1, la membrane 104 est courbée, le signal S1 est à 0, la membrane 4 est au repos, elle est plane. L'extrémité libre 104.2 se déplace en translation le long de la direction X vers l'extrémité fixe 104.1. Cet état est représenté sur la figure 5. Du fait de la liaison 16 entre la face latérale 14 du premier élément mobile 8 et l'extrémité libre 104.2 de la membrane 104, le premier élément mobile 8 pivote du côté de la membrane 104 autour de l'axe Z. Les poutres des liaisons 12 et 16 se déforment.

Le mouvement de rotation autour de l'axe Z du premier élément mobile 8 se poursuit tant que les signaux S1 et S2 sont appliqués, le premier élément mobile 8 a alors un mouvement oscillatoire autour de l'axe Z et l'extrémité 8.1 du premier élément mobile passe alternativement de part et d'autre de l'axe X.

Le deuxième élément mobile 18 guidé en translation le long de l'axe Y, est du fait du pivotement du premier élément mobile 8, déplacé en translation. Il se déplace alternativement vers la gauche et vers la droite selon les représentations des figures 3 et 4. La deuxième pièce mobile 18 a donc un mouvement oscillatoire en translation le long de l'axe Y, de part et d'autre d'une position neutre.

On réalise ainsi un actionneur en translation.

Il sera compris que le deuxième élément mobile pourrait être guidé en translation le long d'une direction qui ne serait pas nécessairement perpendiculaire à l'axe X.

En variante encore, on pourrait réaliser un actionneur en rotation, le deuxième élément mobile serait omis et on récupérerait le mouvement directement sur la première pièce mobile 8.

En variante encore, l'actionneur A2 pourrait ne comporter qu'un actionneur A1 et le bord latéral 14 du premier élément mobile 8 serait relié au substrat. Le débattement angulaire de la première partie mobile serait divisé par deux, ainsi que le débattement axial du deuxième élément mobile.

La forme de la première partie mobile 8 peut être différente de celle représenté sur les figures 2 à 5. Elle peut être choisie pour pouvoir mettre en œuvre des membranes les plus larges et les plus courtes possibles afin de réduire les risques de flambage.

La mise en œuvre du premier élément mobile en rotation 8 offre l'avantage d'apporter une amplification du mouvement de par la différence des bras de levier. On peut alors réaliser un actionneur provoquant une amplitude de déplacement selon l'axe Y relativement importante malgré une amplitude de déplacement des extrémités libres des membranes selon la X réduite et une amplitude de déplacement angulaire réduite du premier élément mobile puisque l'amplitude de déplacement selon X sera proportionnelle à la longueur du bras de levier.

En outre cet actionneur peut très avantageusement être réalisé par des procédés microélectroniques par usinages et dépôts planaires.

Lorsque l'actionneur comporte plusieurs dispositifs de transformation de mouvement, les guidages des extrémités libres peuvent ne pas être selon des directions colinéaires. Il en résulte qu'un plus de la rotation de l'élément mobile, le système peut permettre d'obtenir un mouvement de translation de cet élément, dans ledit plan selon le signal appliqué.

Sur la figure 6, on peut voir un exemple de réalisation d'un actionneur comportant trois dispositifs similaires à l'actionneur A1. Dans l'exemple représenté, les trois dispositifs sont disposés à 120° les uns des autres. Chaque extrémité libre 4.2 des dispositifs est reliée à un élément mobile 8' en forme de platine, destiné à être mise en mouvement par les dispositifs. Les extrémités libres 4.2 de dispositifs sont guidées en translation selon des directions sécantes X, X', X". Dans l'exemple représenté, elles forment un angle de 120° entre elles. Les extrémités 4.2 des actionneurs sont par exemple connectées à la platine 8' par des poutres déformables en flexion.

Ainsi en actionnant simultanément les trois dispositifs, la platine 8' est mise en rotation autour de l'axe Z. En actionnant un ou deux dispositifs, la platine 8' est déplacée en rotation et en translation.

Un système comportant plus de trois dispositifs de transformation de mouvement ne sort pas du cadre de la présente invention.

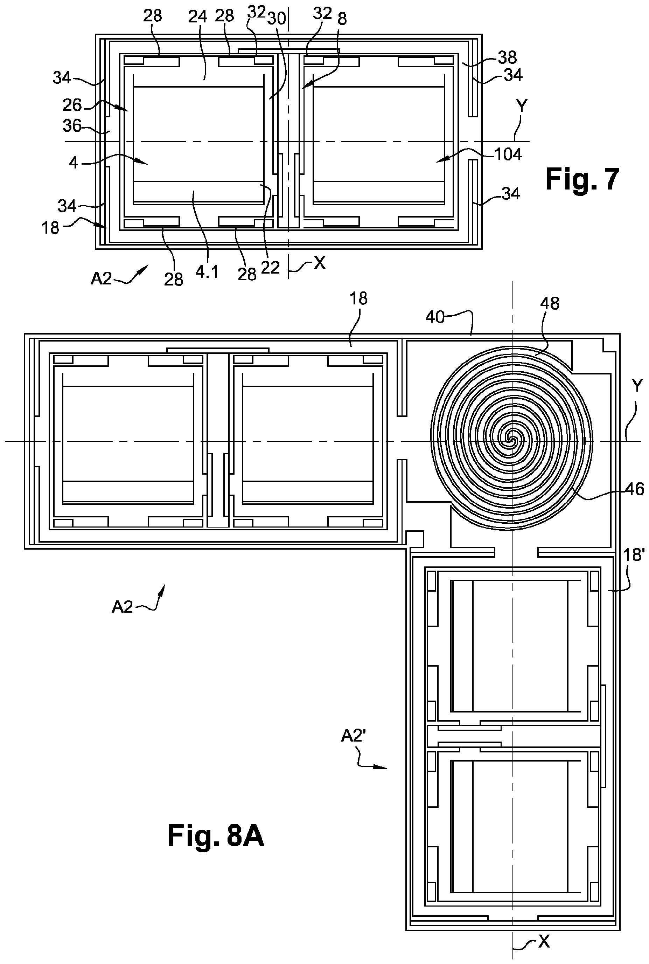

Sur la figure 7, on peut d'ailleurs voir une vue de dessus d'un exemple de réalisation pratique de l'actionneur A2 réalisé par des procédés microélectroniques.

Les références utilisées pour la description des figures 2 à 5 seront reprises pour la description de la figure 7 pour désigner les éléments ayant la même fonction.

Sur la figure 7, on peut voir les deux actionneurs A1 côte à côte comportant chacune une membrane 4, 104, dont la dimension le long de la direction X est avantageusement plus faible que celle selon la direction Y permettant de réduire les risques de flambage.

Les deux actionneurs étant de structure similaire seul l'un des deux sera décrit en détail.

L'extrémité fixe 4.1 de la membrane 4 est ancrée sur le substrat via un plot d'ancrage 22 s'étendant sur toute la largeur de la membrane et l'extrémité libre 4.1 de la membrane comporte un élément transversal 24 s'étendant sur toute la largeur de la membrane. L'élément transversal 24 est similaire au plot d'ancrage sauf qu'il n'est solidaire que de la membrane 4. L'élément transversal 24 offre une raideur transversale dans le plan de l'extrémité libre de la membrane.

L'actionneur comporte également un cadre rigide 26 qui entoure la membrane et dont l'élément transversal 24 forme un des montants.

Le cadre rigide 26 est lui-même suspendu au substrat via quatre poutres 28 aptes à de déformer en flexion le long de la direction X. Deux poutres 28 sont connectées à l'élément transversal 24 et sont parallèles à celui-ci et deux poutres sont reliées au montant 30 du cadre parallèle à l'élément transversal 24. Les quatre poutres 28 forment des moyens de guidage en translation du cadre le long de la direction X et de ce fait de l'élément transversal 24 et donc de l'extrémité libre 4.1 de la membrane.

Le premier élément mobile 8 est disposé entre les deux actionneurs A1, plus particulièrement entre un montant 30 du cadre entourant 26 la membrane 4 et un montant du cadre entourant la membrane 104, ces montants étant perpendiculaires aux montants reliés aux poutres 28.

Le premier élément mobile 8 est relié au montant 30 par deux poutres s'étendant le long de l'axe X et parallèle au montant 30. Le premier élément mobile 8 est également relié au montant du cadre entourant la membrane 104 par deux poutres s'étendant le long de l'axe X.

Le deuxième élément mobile 18 est formé par un cadre rectangulaire entourant les deux actionneurs. L'extrémité 8.1 du premier élément mobile 8 est reliée mécaniquement au deuxième élément mobile 18 au niveau d'une face intérieure d'un montant du deuxième élément mobile 18 perpendiculaire à la direction X et situé du côté des extrémités libres des membranes 4, 104. L'extrémité 8.1 du premier élément mobile 8 est reliée mécaniquement au deuxième élément mobile 18 par deux poutres 32 perpendiculaires à l'axe X et déformables en flexion.

Le deuxième élément mobile 18 est guidé en translation dans la direction Y au moyens de quatre poutres 34, une paire de poutres 34 parallèles à l'axe X relie à un montant 36 du cadre du deuxième élément mobile 18 au substrat, le montant 36 étant parallèle à l'axe X, et une paire de poutres 34 parallèles à l'axe X relie un montant 38 du cadre de l'élément mobile au substrat, le montant 38 étant parallèle à l'axe X. Les poutres 34 sont déformables en flexion. Le deuxième élément mobile 18 est suspendu par rapport au substrat par les poutres 34.

L'actionneur A2 peut être réalisé avec des techniques de la microélectronique par dépôt de couches et gravure.

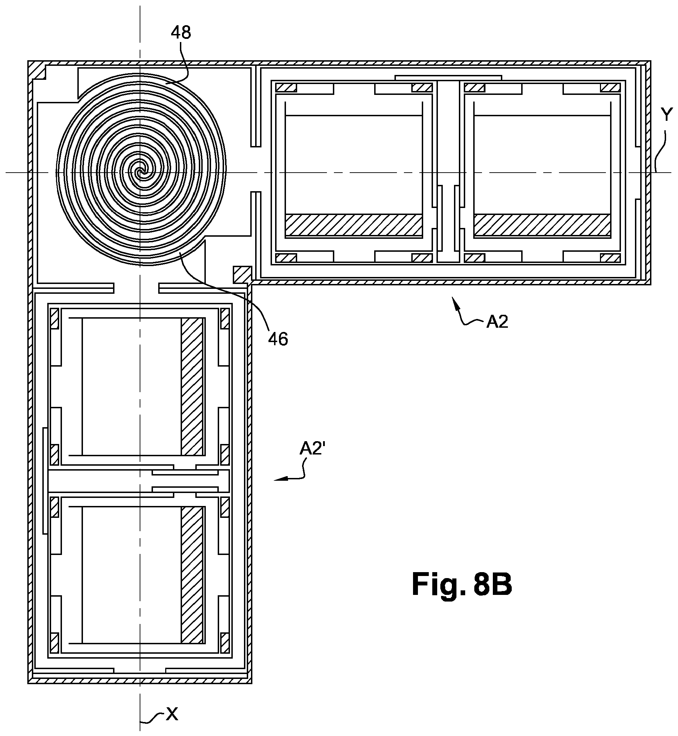

Sur les figures 8A et 8B, on peur voir un exemple d'un compresseur d'un fluide, par exemple un gaz, mettant en œuvre deux actionneurs de type de celui de la figure 6, l'un sera désigné A2 et l'autre A2'. Le fluide comprimé peut être de toute sorte par exemple de l'air, de l'isobutane...

Le compresseur comporte une enceinte étanche 40 comportant une admission du fluide à basse pression et une évacuation du fluide à haute pression (non représentées).

Le compresseur comporte entre l'admission et l'évacuation une zone de compression comprenant deux bras 46, 48 en forme de spirale imbriqués l'un dans l'autre et mobiles l'un par rapport à l'autre. Ils sont conformés et articulés de manière à ce que, du fait de leur déplacement relatif une ou plusieurs poches de fluide se déplacent entre les bras en direction de l'évacuation en voyant leurs volumes se réduire.

Chaque spirale comporte au moins un tour voire plusieurs tours pour définir plusieurs poches de fluide.

De nombreuses formes de spirales différentes sont possibles pour les bras 46 et 48. Par exemple, il s'agit d'une développante de cercle ou d'une spirale d'Archimède.

Chaque bras est relié mécaniquement à un actionneur, le bras 46 est relié rigidement à l'actionneur A2 et le bras 48 est relié rigidement à l'actionneur A2'.

Dans l'exemple représenté, le bras 46 et le deuxième élément mobile 18 sont réalisés d'un seul tenant et le bras 48 et le deuxième élément mobile 18' sont réalisés d'un seul tenant.

Les deux actionneurs sont orientés l'un par rapport à l'autre de sorte que les mouvements de translation qu'ils génèrent soient perpendiculaires. Ainsi le deuxième élément mobile 18 de l'actionneur A2 et le bras 46 se déplacent le long de la direction Y et le deuxième élément mobile 18' de l'actionneur A2' et le bras 48 se déplacent le long de la direction X.

Les deux bras 46 et 48 sont avantageusement réalisés par gravure dans une même couche.

En alimentant les deux actionneurs avec les signaux S1 et S2, les deuxièmes éléments mobiles 18 et 18' ont un mouvement oscillatoire translatif selon des directions Y et X respectivement. Les bras 46 et 48 ont alors un déplacement relatif oscillatoire qui provoque le déplacement de poches de fluide et leur compression, ce fluide comprimé est récupéré au niveau de l'évacuation.

Un tel microcompresseur peut être réalisé par les techniques de la microélectronique et peut être utilisé pour refroidir un composant électronique en comprimant un fluide, par exemple de l'isobutane et en réalisant un cycle de compression - détente, dit cycle de Carnot

En variante, on pourrait envisager un compresseur comportant uniquement un actionneur A2 déplaçant un seul piston en translation dans une cavité, de sorte à comprimer le fluide.

A titre d'exemple uniquement, nous allons donner un dimensionnement de la partie de compression du compresseur.

La surface du compresseur représente 125 mm$^2$.

La surface du dépôt piézoélectrique sur les membranes actionneurs est de 31 mm$^2$.

Le volume initial Vi = 0,5151 mm$^2$ $\times$ 0.5 mm = 0,258 mm$^3$, 0,5 mm étant la hauteur d la zone de compression.

Le volume final Vf = 0,0644mm$^2$ $\times$ 0.5mm = 0,0322 mm$^3$

Le ratio de compression est de : 0,5151/0,0644 = 8.

La cylindrée du compresseur est égale à Vf-Vi = 0,258-0,0322 = 0,226 mm$^3$.

Nous allons donner un exemple de dimensionnement de la partie actuation servant à refroidir de 50°C un composant électronique qui dissipe 200mW. Le compresseur met en œuvre de l'isobutane. Pour cela, l'isobutane est comprimé pour atteindre une différence pression ΔP=3bars. Par exemple, en considérant un débit de

10.26 μmol/la pression en entrée $P_{in}$ = 1 bar à $T_{in}$ = 273 K et la pression en sortie $P_{out}$ = 4 bars.

Connaissant la masse molaire de l'isobutane : 58.12 g/mol, on obtient un débit massique de :

$$\dot{m} = 5.963 \cdot 10^{+} \, g/s$$

La puissance absorbée par l'isobutane est égale à 70,50 mW.

Si l'on considère une fréquence de fonctionnement de f = 5kHz, l'énergie par tour pour comprimer le fluide est de 14,10 μJ.

Si on considère une amplification de mouvement de : 7/2 = 3.5

Le travail mécanique Wméca est égale à 14μJ = $1,4.10^{-5}$J.

Sachant que le coefficient de conversion mécanique / électrique est de 1%, le travail électrique est : Wélec = 100 Wméca = $1,4.10^{-3}$J

Or un dépôt PZT ($\varepsilon_r$ = 1300) en couche mince est une capacité et son travail électrique équivaut aussi à :

$$W_{élec} = \frac{1}{2} C V^2$$

Soit une capacité

$$C = \frac{2 \cdot W_{élec}}{V^2},$$

soit 1120nF à 50V, 280nF à 100V, 100V étant la tension de claquage de 2μm de PZT.

Alors pour une actuation à 100V, la surface nécessaire pour réaliser une capacité de 280nF, est de 0,4865 cm$^2$ (48.65mm$^2$), soit un carré de 7mm de côté.

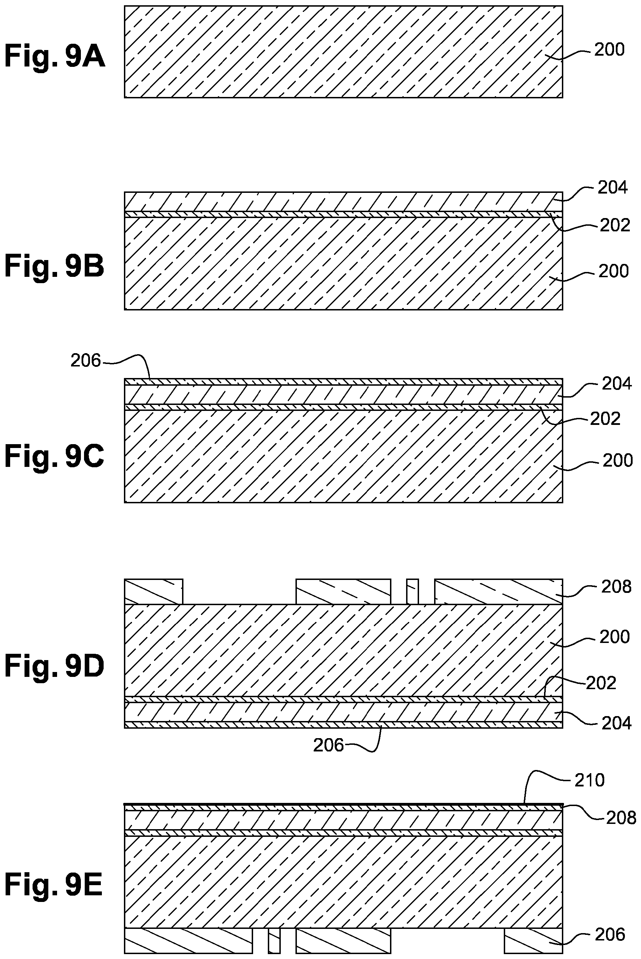

Un exemple de procédé de réalisation d'un dispositif selon l'invention mettant en œuvre les techniques microélectroniques et nanoélectroniques va maintenant être décrit avec les figures 9A à 9J. Il s'agit de réaliser un dispositif MEMS et/ou NEMS.

On part d'un substrat 200 représenté sur la figure 9A par exemple en semi-conducteur, par exemple en silicium, ayant par exemple une épaisseur de 550 μm. Lors d'une étape suivante, on forme une couche 202 de SiO$_2$ par dépôt. La couche 202 a par exemple une épaisseur de 1 μm et on forme sur la couche 202 une couche 204 de silicium amorphe, par exemple par dépôt. La couche 204 a par exemple une épaisseur comprise par exemple entre 2 μm et 4 μm.

L'élément ainsi réalisé est représenté sur la figure 9B.

Lors d'une étape suivante, on forme sur la couche 204 une couche 206 de SiO$_2$, par exemple par dépôt. La couche 206 a par exemple une épaisseur par exemple de 250 nm. Un recuit a ensuite lieu à 800°C pendant par exemple 3h sous O$_2$.

L'élément ainsi réalisé est représenté sur la figure 9C.

Lors d'une étape suivante, on retourne l'élément de la figure 9B. Sur la face arrière on forme une couche d'oxyde 208 à 240°C.

On réalise ensuite une photolithographie et une gravure de la couche 208.

Une étape de retrait de la résine (« stripping » en terminologie anglosaxonne) peut avoir lieu.

L'élément ainsi réalisé est représenté sur la figure 9D.

L'élément de la figure 9D est à nouveau retourné et on forme une couche de platine 210 sur la couche 206, par exemple par dépôt. La couche 210 a par exemple une épaisseur de 100 nm par exemple.

L'élément ainsi réalisé est représenté sur la figure 9E.

Lors d'une étape suivante, on forme une couche de PZT 212 sur la couche 210. Par exemple on étale du PZT obtenu par un procédé sol-gel sur la couche 210 sur une épaisseur de 350 nm par exemple.

On fait ensuite subir un recuit à l'élément, par exemple pendant 1 min à 700°C sous O$_2$.

Ensuite on forme une couche the Ruthénium 214 par exemple par dépôt. La couche a par exemple une épaisseur de 100 nm.

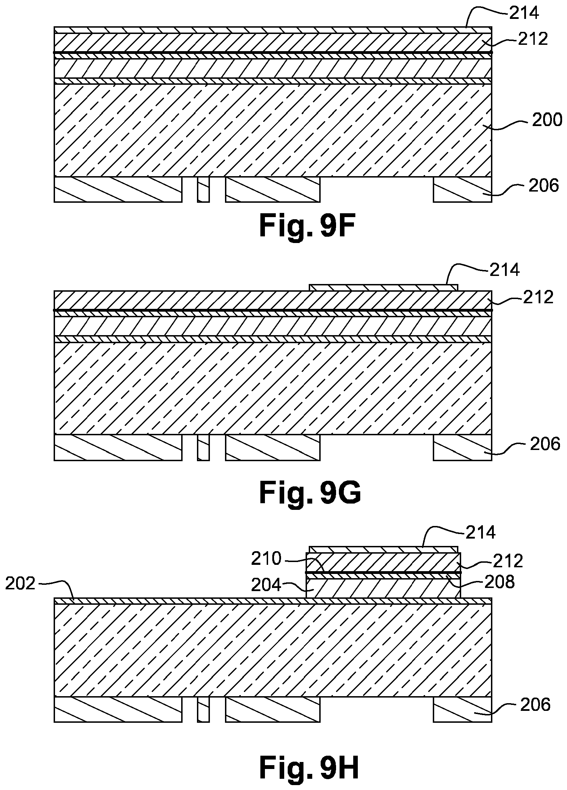

L'élément ainsi réalisé est représenté sur la figure 9F.

Lors d'une étape suivante, on effectue une photolithographie de la couche de Ruthénium 214 et une gravure, par exemple sur toute son épaisseur, de sorte à délimiter une surface qui correspond sensiblement à celle de la membrane de l'actionneur.

Une étape de stripping peut ensuite avoir lieu.

L'élément ainsi réalisé est représenté sur la figure 9G.

Lors d'une étape suivante, on va graver les couches 204, 206, 210, 212 et 214 qui formeront la membrane.

Pour cela, on effectue une photolithographie pour définir la zone à graver.

On effectue ensuite la gravure de la couche 212 par exemple par usinage ionique.

On effectue ensuite la gravure de la couche 210 par exemple par usinage ionique.

On effectue ensuite la gravure des couches 204 et 206, par exemple par usinage ionique.

Une étape de stripping peut ensuite avoir lieu.

L'élément ainsi réalisé est représenté sur la figure 9H.

Lors d'une étape suivante, on met en place un élément de protection par exemple un film sec de protection, par exemple par laminage.

Dans l'exemple représenté, on scelle un substrat 216, par exemple en silicium ou en verre, qui a été préalablement gravé pour comporter une cavité 218 au niveau de la membrane.

L'élément muni du substrat 216 est ensuite retourné.

On grave alors le silicium par usinage ionique du substrat 200 jusqu'à atteindre la couche d'oxyde 202 afin de créer la membrane, les poutres de guidage et les différentes parties mobiles du MEMS.

L'élément ainsi réalisé est représenté sur la figure 9I.

Lors d'une étape suivante, on grave la couche d'oxyde 202 de sorte à libérer la membrane 4, les poutres et les paries mobiles du MEMS.

Dans le cas d'un film sec, celui-ci est retiré par exemple par stripping. L'élément ainsi réalisé est représenté sur la figure 9J.

De préférence, un substrat (non représenté) est scellé sur la couche 208.

## Revendications

1. Système comportant au moins deux dispositifs de transformation d'un mouvement hors-plan en un mouvement dans le plan et/ou inversement et un élément mobile en rotation (8) autour d'un axe de rotation (Z) orthogonal à un plan du système, chaque dispositif de transformation comportant au moins un premier élément déformable (4) hors plan, ledit élément déformable (4) comprenant une première extrémité fixe (4.1) ancrée sur un substrat et une deuxième extrémité libre (4.2) par rapport au substrat, le premier élément déformable (4) de chaque dispositif étant apte à être déformé hors plan par application d'un stimulus indépendant (S1, S2) de sorte que la deuxième extrémité libre (4.2) se rapproche de la première extrémité fixe (4.1) **caractérisé en ce que** ledit dispositif comporte également des moyens de guidage en translation (6) de la deuxième extrémité libre (4.2) dans le plan, **en ce que**, lorsque le premier élément déformable (4) est déformé dans la direction hors plan, la deuxième extrémité libre (4.2) se rapproche de la première extrémité fixe (4.1)selon un mouvement de translation dans le plan et **en ce que** l'élément mobile en rotation (8) est relié mécaniquement aux deuxièmes extrémités libres (4.2, 104.2) des deux éléments déformables (4, 104) desdits dispositifs par des liaisons mécaniques (12, 16) aptes à se déformer.

2. Système selon la revendication 1, dans lequel les deux deuxièmes extrémités (4.2, 104.2) libres sont guidées le long d'une première direction (X).

3. Système selon la revendication 1, dans lequel l'extrémité (4.2, 104.2) libre d'un des dispositifs est guidée le long de la première direction (X) tandis que l'extrémité libre de l'autre des dispositifs est guidée le long d'une autre direction contenue dans ledit plan et non colinéaire à la première direction.

4. Système selon l'une des revendications 1 à 3, comportant des moyens pour appliquer à chaque premier et deuxième élément déformable un stimulus sans contact avec ceux-ci.

5. Système selon l'une des revendications 1 à 4, dans lequel le premier élément déformable (4) est une membrane.

6. Système selon l'une des revendications 1 à 5, dans lequel les moyens de guidage (6) sont formés par des poutres déformables s'étendant perpendiculairement à la première direction (X).

7. Système selon l'une des revendications 1 à 6, dans lequel le premier élément déformable (4) est un bilame et le stimulus est un apport de chaleur.

8. Système selon l'une des revendications 1 à 6, dans lequel le premier élément déformable (4) comporte un dépôt d'un matériau électroactif et le stimulus est l'application d'un champ électrique sur ledit dépôt, le matériau électroactif étant avantageusement un matériau piézoélectrique et le champ électrique est avantageusement généré par des électrodes disposées de part et d'autres et/ou de façon coplanaire audit dépôt de matériau piézoélectrique.

9. Système selon l'une des revendications 1 à 8, dans lequel les liaisons mécaniques déformables sont formées par des poutres flexibles.

10. Système selon l'une des revendications 1 à 9, comportant un élément mobile en translation (18) dans le plan relié mécaniquement à l'élément mobile en rotation (8) de sorte que la rotation de l'élément mobile en rotation (8) provoque la translation dans le plan de l'élément mobile en translation (18), l'élément mobile en rotation (8) étant avantageusement relié mécaniquement à l'élément mobile en translation (18) par des poutres flexibles.

11. Système selon la revendication 10, comportant des moyens de guidage en translation dans le plan de l'élément mobile en translation (18), les moyens de guidage en translation de l'élément mobile en translation (18) guidant avantageusement l'élément mobile en translation (18) selon une direction (Y) orthogonale à la première direction (X).

12. Système selon la revendication 10 ou 11, dans lequel l'élément mobile en rotation (8) est situé entre les deux éléments déformables (4, 104) et l'élément mobile en translation (18) a la forme d'un cadre entourant les deux éléments déformables (4, 104), l'élément mobile en rotation (8) étant articulé sur un bord intérieur de l'élément mobile en translation (18) en forme de cadre.

13. Actionneur comportant au moins un système selon l'une des revendications 1 à 12 et une unité de commande envoyant un stimulus à chacun des dispositifs, les stimuli étant avantageusement déphasés de π.

14. Actionneur en translation comportant au moins un système selon l'une des revendications 1 à 12 et une unité de commande envoyant un stimulus à chacun des dispositifs.

15. Actionneur en translation selon la revendication 13 ou 14, dans lequel le stimulus est sinusoïdal.

16. Compresseur comportant une cavité, un piston mobile dans la cavité, au moins deux actionneurs de translation (A2, A2') selon la revendication 14 ou 15, chacun des pistons (46, 48) étant relié mécaniquement à un élément mobile en translation de sorte que le déplacement relatif des pistons génère une augmentation de pression dans la cavité, les premier et deuxième pistons (46, 48) étant avantageusement conformés en spirale et sont imbriqués l'un dans l'autre, de sorte à créer des poches de fluide entre les spirales.

17. Système de récupération d'énergie comportant récupérateur d'énergie comportant au moins un système selon les revendications 1 à 12 et une unité collectant le courant électrique généré par ledit dispositif ou ledit système, le premier élément déformable (4) comportant avantageusement un dépôt d'un matériau électroactif qui génère un courant électrique lorsqu'il est déformé, avantageusement un dépôt de matériau piézoélectrique.

**Patentansprüche**

1. System, umfassend wenigstens zwei Vorrichtungen zur Umwandlung einer Bewegung aus der Ebene in eine Bewegung in der Ebene und/oder umgekehrt, und ein Element (8), das drehbeweglich um eine Drehachse (Z) orthogonal zu einer Ebene des Systems ist, wobei jede Umwandlungsvorrichtung wenigstens ein erstes aus der Ebene verformbares Element (4) umfasst, wobei das verformbare Element (4) ein erstes festes Ende (4.1) umfasst, das auf einem Substrat verankert ist, und ein bezüglich des Substrats freies zweites Ende (4.2), wobei das erste verformbare Element (4) von jeder Vorrichtung dazu ausgelegt ist, aus der Ebene durch Anwendung eines unabhängigen Stimulus (S1, S2) derart verformt zu werden, dass sich das zweite freie Ende (4.2) dem ersten festen Ende (4.1) nähert, **dadurch gekennzeichnet, dass** die Vorrichtung ferner Mittel (6) zur Translationsführung des zweiten freien Endes (4.2) in der Ebene umfasst, dass dann, wenn das erste verformbare Element (4) in der Richtung aus der Ebene verformt wird, das zweite freie Ende (4.2) sich dem ersten festen Ende (4.1) gemäß einer Translationsbewegung in der Ebene nähert, und dass das drehbewegliche Element (8) mechanisch mit den zweiten freien Enden (4.2, 104.2) der zwei verformbaren Elemente (4, 104) der Vorrichtungen mittels mechanischer Verbindungen (12, 16) verbunden ist, die dazu ausgelegt sind, sich zu verformen.

2. System nach Anspruch 1, bei dem die zwei freien zweiten Enden (4.2, 104.2) entlang einer ersten Richtung (X) geführt werden.

3. System nach Anspruch 1, bei dem das freie Ende (4.2, 104.2) von einer der Vorrichtungen entlang der ersten Richtung (X) geführt wird, wohingegen das freie Ende der anderen von den Vorrichtungen entlang einer anderen Richtung geführt wird, die in der Ebene enthalten und nicht kollinear mit der ersten Richtung ist.

4. System nach einem der Ansprüche 1 bis 3, umfassend Mittel zum Anwenden eines Stimulus auf jedes erste und zweite verformbare Element ohne Kontakt mit selbigen.

5. System nach einem der Ansprüche 1 bis 4, bei dem das erste verformbare Element (4) eine Membran ist.

6. System nach einem der Ansprüche 1 bis 5, bei dem die Führungsmittel (6) durch verformbare Balken gebildet sind, die sich orthogonal zu der ersten Richtung (X) erstrecken.

7. System nach einem der Ansprüche 1 bis 6, bei dem das erste verformbare Element (4) ein Bimetall ist und der Stimulus eine Wärmezufuhr ist.

8. System nach einem der Ansprüche 1 bis 6, bei dem das erste verformbare Element (4) eine Aufbringung eines elektroaktiven Materials umfasst, und der Stimulus das Anlegen eines elektrischen Felds an die Aufbringung ist, wobei das elektroaktive Material vorzugsweise ein piezoelektrisches Material ist, und das elektrische Feld vorzugsweise durch Elektroden erzeugt wird, die auf beiden Seiten und/oder in koplanarer Weise an der Aufbringung aus piezoelektrischem Material angeordnet sind.

9. System nach einem der Ansprüche 1 bis 8, bei dem die verformbaren mechanischen Verbindungen durch flexible Balken gebildet sind.

**10.** System nach einem der Ansprüche 1 bis 9, umfassend ein in der Ebene translationsbewegliches Element (18), das mechanisch mit dem drehbeweglichen Element (8) derart verbunden ist, dass die Drehung des drehbeweglichen Elements (8) die Translation des translationsbeweglichen Elements (18) in der Ebene bewirkt, wobei das drehbewegliche Element (8) vorzugsweise mechanisch mittels flexibler Balken mit dem translationsbeweglichen Element (18) verbunden ist.

**11.** System nach Anspruch 10, umfassend Mittel zur Translationsführung des translationsbeweglichen Elements (18) in der Ebene, wobei die Mittel zur Translationsführung des translationsbeweglichen Elements (18) das translationsbewegliche Element (18) vorzugsweise entlang einer Richtung (Y) orthogonal zu der ersten Richtung (X) führen.

**12.** System nach Anspruch 10 oder 11, bei dem das drehbewegliche Element (8) zwischen den zwei verformbaren Elementen (4, 104) angeordnet ist, und das translationsbewegliche Element (18) die Form eines Rahmens hat, der die zwei verformbaren Elemente (4, 104) umgibt, wobei das drehbewegliche Element (8) an einem inneren Rand des rahmenförmigen translationsbeweglichen Elements (18) angelenkt ist.

**13.** Aktor, umfassend wenigstens ein System nach einem der Ansprüche 1 bis 12, und eine Steuereinheit, die einen Stimulus an jede der Vorrichtungen schickt, wobei die Stimuli vorzugsweise um $\pi$ phasenversetzt sind.

**14.** Translationsaktor, umfassend wenigstens ein System nach einem der Ansprüche 1 bis 12 und eine Steuereinheit, die einen Stimulus an jede der Vorrichtungen schickt.

**15.** Translationsaktor nach Anspruch 13 oder 14, bei dem der Stimulus sinusförmig ist.

**16.** Kompressor, umfassend einen Hohlraum, einen beweglichen Kolben in dem Hohlraum, wenigstens zwei Translationsaktoren (A2, A2') nach Anspruch 14 oder 15, wobei jeder der Kolben (46, 48) mechanisch mit einem translationsbeweglichen Element derart verbunden ist, dass die Relativverlagerung der Kolben eine Druckerhöhung in dem Hohlraum bewirkt, wobei der erste und der zweite Kolben (46, 48) vorzugsweise spiralförmig gestaltet und ineinander verschachtelt sind, derart, dass Fluidtaschen zwischen den Spiralen gebildet werden.

**17.** System zur Energierückgewinnung, umfassend eine Energierückgewinnungsvorrichtung, umfassend wenigstens ein System nach den Ansprüchen 1 bis 12 und eine Einheit, die den elektrischen Strom sammelt, der durch die Vorrichtung oder das System erzeugt wird, wobei das erste verformbare Element (4) vorzugsweise eine Aufbringung aus einem elektroaktiven Material umfasst, die einen elektrischen Strom erzeugt, wenn sie verformt wird, vorzugsweise eine Aufbringung aus einem piezoelektrischen Material.

**Claims**

**1.** A system comprising at least two devices to convert out-of-plane motion to in-plane motion and/or conversely and an element (8) mobile in rotation about a rotational axis (Z) orthogonal to a plane of the system, each conversion device comprising at least a first out-of-plane deformable element (4), said deformable element (4) comprising a first fixed end (4.1) anchored on a substrate and a second free end (4.2) relative to the substrate, the first deformable element (4) of each device being capable of deforming out-of-plane through application of an independent stimulus (S1, S2) so that the second free end (4.2) draws close to the first fixed end (4.1), **characterised in that** said device also comprises means (6) for guiding the second free end (4.2) in in-plane translation, **in that**, when the first deformable element (4) is deformed out-of-plane, the second free end (4.2) draws close to the first fixed end (4.1) by in-plane translational movement and **in that** the rotationally mobile element (8) is mechanically linked to the second free ends (4.2, 104.2) of the two deformable elements (4, 104) of said devices by mechanical links (12, 16) capable of being deformed.

**2.** The system according to claim 1, wherein the two second free ends (4.2, 104.2) are guided along a first direction (X).

**3.** The system according to claim 1, wherein the free end (4.2, 104.2) of one of the devices is guided along the first direction (X) whilst the free end of the other of the devices is guided along another direction contained in said plane and non-collinear with the first direction.

**4.** The system according to any one of claims 1 to 3, including means to apply a stimulus to each first and second deformable element without contact.

**5.** The system according to any one of claims 1 to 4, wherein the first deformable element (4) is a membrane.

**6.** The system according to any one of claims 1 to 5, wherein the guide means (6) are formed by deformable beams extending perpendicular to the first direction (X).

7. The system according to any one of claims 1 to 6, wherein the first deformable element (4) is a bimetallic element and the stimulus is the application of heat.

8. The system according to any one of claims 1 to 6, wherein the first deformable element (4) comprises a deposit of electroactive material and the stimulus is application of an electric field to said deposit, said electroactive material being advantageously a piezoelectric material and the electric field is advantageously generated by electrodes arranged either side of and/or co-planar with said deposit of piezoelectric material.

9. The system according to any one of claims 1 to 8, wherein the mechanical deformable links are formed by flexible beams.

10. The system according to any one of claims 1 to 9, comprising an in-plane translationally mobile element (18) mechanically linked to the rotationally mobile element (8) so that rotation of the rotationally mobile element (8) causes in-plane translation of the translationally mobile element (18), the rotationally mobile element (8) being advantageously mechanically linked to the translationally mobile element (18) via flexible beams.

11. The system according to claim 10, including means to guide the translationally mobile element (18) in in-plane translation, said means to guide in translation the translationally mobile element (18) advantageously guiding the translationally mobile element (18) in a direction (Y) orthogonal to the first direction (X).

12. The system according to claim 10 or 11, wherein the rotationally mobile element (8) is positioned between the two deformable elements (4, 104), and the translationally mobile element (18) is in the form of a frame surrounding the two deformable elements (4, 104), the rotationally mobile element (8) being hinged on an inner edge of the frame-shaped, translationally mobile element (18).

13. An actuator comprising at least one system according to any one of claims 1 to 12, and a control unit sending a stimulus to each of the devices, the stimuli being advantageously phase-shifted by $\pi$.

14. A translational actuator comprising at least one system according to any one of claims 1 to 12, and a control unit sending a stimulus to each of the devices, the actuator being an actuator in translation.

15. The actuator according to claim 13 or 14, wherein the actuator is a translational actuator and wherein the stimulus is sinusoidal.

16. A compressor having a cavity, a piston mobile inside the cavity, at least two translational actuators (A2, A2') according to claim 14 or 15, each of the pistons (46, 48) being mechanically linked to a translationally mobile element so that the relative displacement of the pistons generates a pressure increase in the cavity, the first and second pistons (46, 48) advantageously having a spiral conformation and are imbricated one in the other to create pockets of fluid between the turns.

17. An energy recovery system comprising an energy recovery device having at least one system according to any one of claims 1 to 12, and a unit collecting the electric current generated by said device or said system, the first deformable element (4) advantageously comprising a deposit of electroactive material which generates an electric current when it is deformed, advantageously a deposit of piezoelectric material.

Fig. 1A

Fig. 1B

Fig. 1C

Fig. 2

Fig. 3

Fig. 4

Fig. 5

Fig. 6

**Fig. 7**

**Fig. 8A**

**Fig. 8B**

**Fig. 9A**

200

**Fig. 9B**

204
202
200

**Fig. 9C**

206
204
202
200

**Fig. 9D**

208
200
202
204
206

**Fig. 9E**

210
208
206

**Fig. 9F**

214
212
200
206

**Fig. 9G**

214
212
206

**Fig. 9H**

210
202
204

214
212
208
206

Fig. 9I

Fig. 9J

Fig. 10

**EP 3 037 381 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8234951 B